# EUROPÄISCHE PATENTSCHRIFT

(11) **EP 1 753 990 B1**
(45) Veröffentlichungstag und Bekanntmachung des Hinweises auf die Patenterteilung: **20.08.2014**
(21) Anmeldenummer: 05756092.2
(22) Anmeldetag: 31.05.2005
(51) Int. Cl.: F16K 51/02, F16K 3/10, H01L 21/00

(54) **SCHLEUSENVORRICHTUNG**
LOCKING DEVICE
DISPOSITIF DE BLOCAGE

(30) Priorität: 08.06.2004 DE 102004027752
(43) Veröffentlichungstag der Anmeldung: 21.02.2007
(73) Patentinhaber: Leybold Optics GmbH, 63755 Alzenau (DE)
(72) Erfinder: RÖDER, Mario, 63571 Gelnhausen (Roth) (DE); MÜLLER, Alexander, 63594 Hasselroth (DE); CASPARI, Andreas, 63500 Seligenstadt (DE); VOGT, Thomas, 63538 Grosskrotzenburg (DE); KLESEN, Christof, 64397 Modautal (DE)
(74) Vertreter: Pohlmann, Bernd Michael
(86) Internationale Anmeldenummer: PCT/EP2005/005825
(87) Internationale Veröffentlichungsnummer: WO 2005/121621

(56) Entgegenhaltungen:
- DE-A1- 3 724 465
- DE-A1- 3 941 502
- US-A- 2 556 225
- US-A- 3 665 958
- US-A- 5 379 984

## Beschreibung

Die Erfindung betrifft eine Schleusenvorrichtung nach dem Oberbegriff des unabhängigen Patentanspruchs.

Bei Schleusenventilen von Vakuumkammern, insbesondere für sogenannte Inline-Anlagen zur Substratbeschichtung, treten häufig Probleme bei dem Abdichten der Schleusenventilklappe gegenüber dem Rezipienten auf. Ein wesentlicher Einflussfaktor bei Schleusenventilen mit schwenkbaren Schleusenventilklappen ist dabei eine Verformung, insbesondere eine Verdrehung der Schwenkwelle sowie der Schleusenventilklappe beim Andrücken der Klappe gegen den Rezipienten im Verschlusszustand des Schleusenventils. Die Folge der daraus resultierenden Verformungen ist ein ungleichmäßiger Anpressdruck der Schleusenventilklappe an ein die Schleusenöffnung umfassendes elastisches Dichtungselement, was dazu führt, dass entlang des Verlaufs des Dichtungselements nicht an allen Stellen die zur zuverlässigen Abdichtung notwendige Mindestanpresskraft sichergestellt ist. Ein gängiges, jedoch aufwändiges und kostentreibendes Konzept, um dennoch eine ausreichende Abdichtung zu gewährleisten, besteht darin, sehr groß dimensionierte Bauteile einzusetzen, mit denen ein ausreichend hohes Drehmoment und ein entsprechender Anpressdruck aufgebracht werden kann.

Aus der DE-OS 39 41 502 ist eine Vorrichtung mit einer Unterdruckkammer und einem beiderseits der Unterdruckkammer vorgesehenen Schleusenventil bekannt. Die Ventilplatte weist eine längliche, parallel epipede Form auf, wobei die Ventilplatte mit jeweils drei Lagerböcken fest verbunden ist. Durch die Lagerböcke ist eine Achse hindurchgeführt, die ihrerseits wiederum mit Schwenkhebeln in Verbindung steht und von einem Zahnstangentrieb mit Motor verschwenkbar ist. Die Ventilplatte ist gegenüber dem um ortsfeste Lager bewegbaren Hebel kippbar gehalten, so dass die Dichtflächen der Ventilplatte auf die Dichtfläche am Gehäuse der Unterdruckkammer anpressbar sind. Es hat sich jedoch gezeigt, dass mit diesem bekannten Schleusenventil höchste Anforderungen an die Dichtheit nicht erreicht werden können, weil der erforderliche Dichtring im Verschlusszustand zu ungleichmäßig beansprucht wird und sich die Dichtplatte bzw. die Antriebsachse im Verschlusszustand in einem zu großen Maße durchbiegen. Dieses Problem tritt insbesondere auf, falls die Ventilplatte ein extremes Breiten-/Längenverhältnis aufweist, wie es typisch bei Inline-Anlagen für flache Großflächensubstrate erforderlich ist.

Aus der DE 42 03 473 A1 ist ferner bereits eine Drehschleuse zum Ein- und/oder Ausbringen eines Substrats von der einen in eine benachbarte Behandlungskammer oder aus dem atmosphärischen Raum in eine Kammer geringeren Drucks bekannt mit einer torartigen, in ortsfesten Lagern gehaltenen Ventilplatte und einem mit dieser in Wirkverbindung stehenden Schließmotor und mit einem die Schleusenöffnung umschließenden rahmenförmigen Dichtelement. Die Ventilplatte ist in einem sich etwa parallel zu ihr erstreckenden Ventilbalken über mindestens ein elastisch verformbares Zwischenglied angelenkt, wobei der Ventilbalken seinerseits zwei zueinander diametral gegenüberliegende Lagerzapfen aufweist, die drehfest mit außerhalb der Kammer vorgesehenen Antriebsmotoren gekoppelt sind. Der Ventilbalken ist als biegesteifes Profil ausgebildet. Ein Nachteil dieser Schleuse ist der hohe konstruktive Aufwand und die Schwierigkeit, eine Partikelkontamination aufgrund einer Torsion der Ventilplatte auszuschließen.

Aus der US 5,379,984 ist ein Schleusenventil mit einem Ventilkörper, durch den sich ein langer enger Schlitz erstreckt, bekannt. Auf einer Öffnungsseite des Schlitzes ist eine Ventilplatte angeordnet, die sich zu einer schmalen Dichtungskontaktfläche verjüngt. Ein bewegbares Dichtungselement ist vorgesehen, um einen gespreizten Schlauch als dichtende Membran auf die Kontaktfläche aufzulegen. Da das Dichtelement an eine Schwenkachse angelenkt ist, ist es bei dieser vorbekannten Ventilvorrichtung schwierig, einen uniformen Druck entlang des Öffnungsverlaufs zu gewährleisten. So kann dieses Schleusenventil dem Druckunterschied zwischen Vakuum und Atmosphärendruck nur widerstehen, wenn das Ventil so angeordnet ist, dass der Atmosphärendruck schließkraftunterstützend in die Schließrichtung der Ventilklappe wirkt.

Aus der US 6,263,542 B1 ist ferner eine Klappenanordnung mit einer Schwenklagerung für eine Vakuumkammer bekannt. Der Klappenkörper wird von der Schwenklagerung durch eine aufwändige flexible, beispielsweise federnde Verbindung, entkoppelt. Damit soll ein ungleichmäßiger Andruck der Dichtung, der zu Undichtigkeiten führen könnte, vermieden werden.

Aus dem Dokument DE 37 24 465 A1 ist eine Schleusenvorrichtung für eine in einer Wandung zwischen einem ersten und einem zweiten Rezipienten angeordneten Schleusenöffnung mit einem im Innenraum des ersten Rezipienten anordenbaren Absperrorgan bekannt. Das Dokument zeigt eine Vielzahl von länglichen Elektromagneten, die in einem Flanschteil eingebettet sind, der aus nichtmagnetisierbarem Edelstahl besteht. Die Spulen der Elektromagneten umschließen ein längliches magnetisch permeables Kernteil aus Weicheisen, wobei die verschiedenen Elektromagnete in Reihe an einer Stromversorgung angeschlossen sind. In einem Bereich des Absperrorgans sind Magnetaufbauten vorgesehen, die den Elektromagneten zugeordnet sind. Zum Schließen und/oder Öffnen der Schleusenöffnung kann mittels der ersten und zweiten Magneteinrichtung eine positive und/oder negative Anpresskraft zwischen Absperrorgan und Gegenplatte erzeugt werden.

Aufgabe der vorliegenden Erfindung ist die Schaffung einer Schleusenvorrichtung, mit der eine einfache und sichere Abdichtung einer in einer Wandung angeordneten Schleusenöffnung erreicht werden kann.

Die Aufgabe wird erfindungsgemäß mit den Merkmalen des unabhängigen Patentanspruchs gelöst. Bevorzugte Weiterbildungen der Erfindung sind den abhängigen Ansprüchen zu entnehmen.

Die Schleusenvorrichtung ist für eine in einer Wandung zwischen einem ersten und einem zweiten Rezipienten angeordneten Schleusenöffnung mit einem im Innenraum des ersten Rezipienten anordenbaren Absperrorgan oder für eine Schleusenöffnung mit einem an einer Trennstelle zwischen einem Rezipienten und einem Bereich mit dauerhaft anstehendem atmosphärischen Druck angeordneten Absperrorgan vorgesehen und umfasst eine dem Absperrorgan zugeordneten Gegenplatte.

Eine erste Magneteinrichtung ist in einem Bereich der Gegenplatte und eine der ersten Magneteinrichtung zugeordnete zweite Magneteinrichtung in einem Bereich des Absperrorgans vorgesehen. Zum Schließen der Schleusenöffnung mittels der ersten und zweiten Magneteinrichtung ist eine positive Anpresskraft zwischen Absperrorgan und Gegenplatte erzeugbar.

Erfindungsgemäß ist vorgesehen, daß die erste Magneteinrichtung als schaltbare Magnetspule ausgebildet ist, die die Schleusenöffnung entlang des Öffnungsverlaufs ein- oder mehrfach umfasst und die zweite Magneteinrichtung eine ferromagnetische Komponente aufweist.

Dadurch, daß die erste Magneteinrichtung als schaltbare Magnetspule ausgebildet ist, die die Schleusenöffnung entlang des Öffnungsverlaufs ein- oder mehrfach umfasst und daß die zweite Magneteinrichtungen eine ferromagnetische Komponente umfasst wird eine besonders kostengünstige Kombination aus Schaltbarkeit, einem einfachen und robusten Aufbau und einer hohen Anpresskraft zwischen Absperrorgan und Gegenplatte erreicht.

Vorzugsweise ist eine nicht-gleichmäßig geformte Schleusenöffnung, insbesondere mit einem an einen Transport von senkrecht an einem Substratcarrier hängenden Substraten angepassten Schleusenöffnungsprofil, vorgesehen, womit minimale Spalte zwischen der Schleusenöffnung und den durch die Öffnung hindurch bewegten Teilen erreicht werden können. Diese Ausführung reduziert unerwünschte Überströmeffekte zwischen benachbarten Kammern mit unterschiedlichen Drücken und/oder Gasgemischen.

Wenn die Magneteinrichtungen derart entlang des Verlaufes der Schleusenöffnung angeordnet sind, dass das Absperrorgan im Verschlusszustand der Schleusenöffnung torsionsfrei ist, sind damit unterschiedliche Anpressdrucke entlang des Verlaufs der Schleusenöffnung und damit Undichtigkeiten oder Überströmungen weitgehend vermeidbar.

Als Absperrorgan ist es je nach Platzverhältnissen und anderen Einflussfaktoren zweckmäßig, eine mittels einer Schwenkeinrichtung positionierbare schwenkbare Klappe oder eine Schiebereinrichtung, welche mittels einer linearen Bewegungseinrichtung positionierbar ist, einzusetzen. Die Schwenkeinrichtung bzw. die lineare Bewegungseinrichtung ermöglichen die Einleitung und Beendigung einer Schließ- bzw. Öffnungsbewegung, die im übrigen vorzugsweise automatisiert und/oder steuerbar ist.

Wie an sich bekannt ist, ist zur Abdichtung ein verformbares Dichtungselement, vorzugsweise ein Rundschnurring, in einem Bereich der Gegenplatte und/oder des Absperrorgans vorgesehen. Bevorzugt sind gummielastische Rundringe, die zuverlässig, kostengünstig und leicht austauschbar sind.

Besonders bevorzugt ist eine Ausführungsform der Vorrichtung, bei der das Absperrorgan eine Komponente aufweist, die aus einem ferromagnetischen Blech gebildet ist.

Zur Verbesserung der Abdichtfunktion ist es vorteilhaft, wenn das Absperrorgan als Platte mit geringer Biegesteifigkeit ausgebildet ist, so dass durch eine gezielt ermöglichte Deformation des Absperrorgans im Verschlusszustand eine sichere Abdichtung auch bei größeren Fertigungstoleranzen der beteiligten Komponenten gewährleistet ist.

Weitere Ausführungsformen und Vorteile der Erfindung sind auch unabhängig von ihrer Zusammenfassung in Patentansprüchen im folgenden ohne Beschränkung der Allgemeinheit anhand von Zeichnungen beschrieben.

Es zeigen in stark schematischer Darstellung:
- Figur 1: eine erfindungsgemäße Schleusenvorrichtung in einem Horizontalschnitt
- Figur 2: eine erfindungsgemäße Schleusenvorrichtung in einem Vertikalschnitt
- Figur 3: eine Detailansicht einer Schleusenöffnung mit entlang des Verlaufs der Schleusenöffnung angeordneten Magneteinrichtungen.

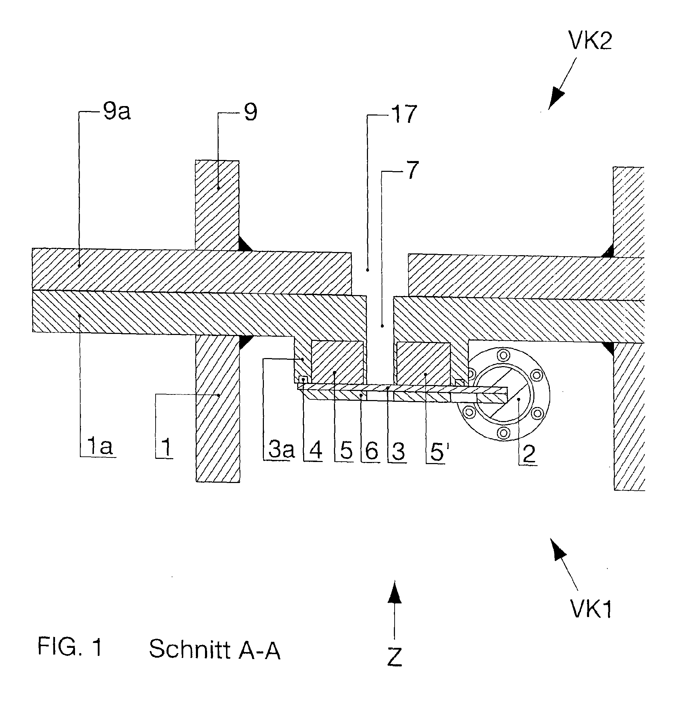

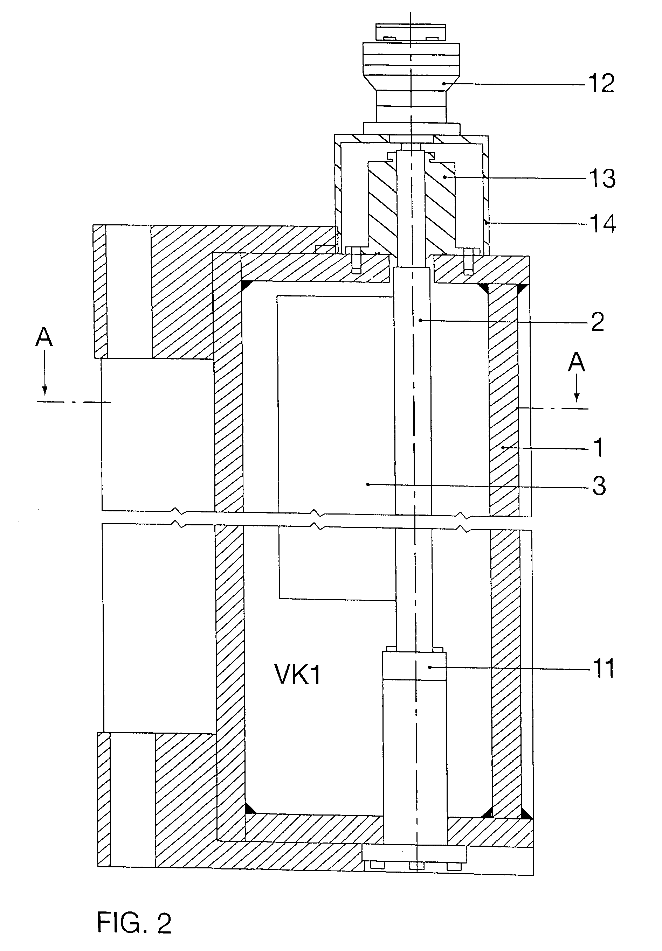

In den Figuren 1 und 2 sind jeweils ein Horizontalschnitt A-A bzw. ein Vertikalschnitt senkrecht zu A-A einer erfindungsgemäßen Schleusenvorrichtung für eine in einer Wandung zwischen einem ersten und einem zweiten Rezipienten angeordneten Schleusenöffnung dargestellt. Bei den Rezipienten handelt es sich um Vakuumkammern. Eine derartige Schleusenvorrichtung wird vorteilhaft bei sogenannten Inline-Systemen zur Herstellung von Substraten für flache Displays eingesetzt. Typischerweise sind derartige Substrate ca. 1 mm dick, rechteckig und haben eine Größe von 1000 x 1200 mm oder mehr. Die Substrate werden hängend in dem Inline-System entlang eines linearen oder U-förmigen Pfades durch eine Anzahl von Vakuumkammern geführt, die durch die Schleusen voneinander separierbar sind. Bedingt durch die Substratdimensionen sind die typischen Schleusenöffnungen charakterisiert durch ein extremes Längen-/Breitenverhältnis. Es versteht sich jedoch, dass die erfindungsgemäße Schleusenvorrichtung auch für andere Schleusenöffnungsprofile eingesetzt werden kann. Die erfindungsgemäße Schleusenvorrichtung ist aus dünnwandigen und leichten Bauelementen ausführbar und daher besonders geeignet für automatisiertes Substrat-Handling mit einer hohen Durchsatzrate und dementsprechend schneller Taktung der Schleusenventile, da nur geringe Massen bewegt werden müssen.

In Figur 1 ist zwischen einer ersten Vakuumkammer VK1 und einer zweiten Vakuumkammer VK2 eine als Rechteckspalt ausgebildete Schleusenöffnung angeordnet, die im vorliegenden Fall einen ersten Spaltbereich 7, der der Vakuumkammer VK1 und einen zweiten Spaltbereich 17, der der Vakuumkammer VK2 zugeordnet ist, umfasst. Zwischen den Vakuumkammern VK1 und VK2 erstreckt sich eine Wandung, die aus einem Verbindungsflansch 1a der Vakuumkammer VK1 und einem Verbindungsflansch 9a der Vakuumkammer VK2 gebildet ist, die jeweils mit einer Kammerwand 1 bzw. 9 der Vakuumkammer VK1 bzw. VK2 verbunden sind. Die Schleusenöffnung kann durch ein als rechteckige Klappe 3 ausgebildetes Absperrorgan in Zusammenwirken mit einer Gegenplatte 3a verschlossen werden. Die Schleusenöffnung wird in dem von dem Spaltbereich 7 gebildeten Bereich von der Gegenplatte 3a umfasst. Die Gegenplatte 3a weist ferner ein verformbares Dichtelement, vorzugsweise einen gummielastischen Rundschnurring, auf, der im Verschlusszustand deformiert wird und eine drucksichere Abdichtung gewährleistet.

In einer Weiterbildung der Erfindung weist das Absperrorgan eine von einer Rechteckform unterschiedliche Form auf, die vorzugsweise dem Schleusenöffnungsprofil angepasst ist.

Die Klappe 3 ist an einer Schwenkwelle 2 angeordnet, die über eine Drehdurchführung 13 mit einem Schwenkantrieb 12 bewegbar ist.

Zur Halterung und Lagerung von Schwenkantrieb bzw. Schwenkwelle sind eine Lagerstelle 11 und eine Halterung 14 vorgesehen. Der Schwenkantrieb 12 dient der Einleitung und Beendigung von Schließ- und Öffnungsbewegungen. Als Schwenkantrieb ist ein Pneumatikzylinder vorgesehen, wobei es sich versteht, dass auch hydraulische oder elektrische Antriebe in Frage kommen.

Erfindungsgemäß ist in einem Bereich der Gegenplatte 3a eine erste Magneteinrichtung mit schaltbaren Magnetspulen 5, 5'und in einem Bereich des Absperrorgans eine der ersten Magneteinrichtung zugeordnete zweite Magneteinrichtung 6 vorgesehen. Die zweite Magneteinrichtung 6 ist als eine ferromagnetische Platte oder Streifenanordnung 6 ausgebildet, die auf der Rückseite der Klappe 3 angeordnet ist. Bei Aktivierung der Magnetspulen 5, 5' wird eine Anpresskraft zwischen Klappe 3 und den Spulen 5, 5', d.h. zwischen Absperrorgan und Gegenplatte 3a erzeugt.

Es versteht sich, dass von der Erfindung verschiedene Ausbildungsformen der Klappe 3 umfasst werden, insbesondere kann die Klappe 3 aus einem ferromagnetischen Blech, vorzugsweise mit geringer Biegesteifigkeit, hergestellt sein. Bevorzugt ist eine Blechdicke zwischen 0,5 und 10 mm, besonders bevorzugt zwischen 1 und 8 mm. Bei einer ferromagnetischen Klappe 3 kann die ferromagnetische Platte 6 entfallen, da die Klappe 3 selbst die zweite Magneteinrichtung darstellt. Ferner kann ein verformbares Dichtelement alternativ oder zusätzlich auch an der Platte 3 angeordnet sein.

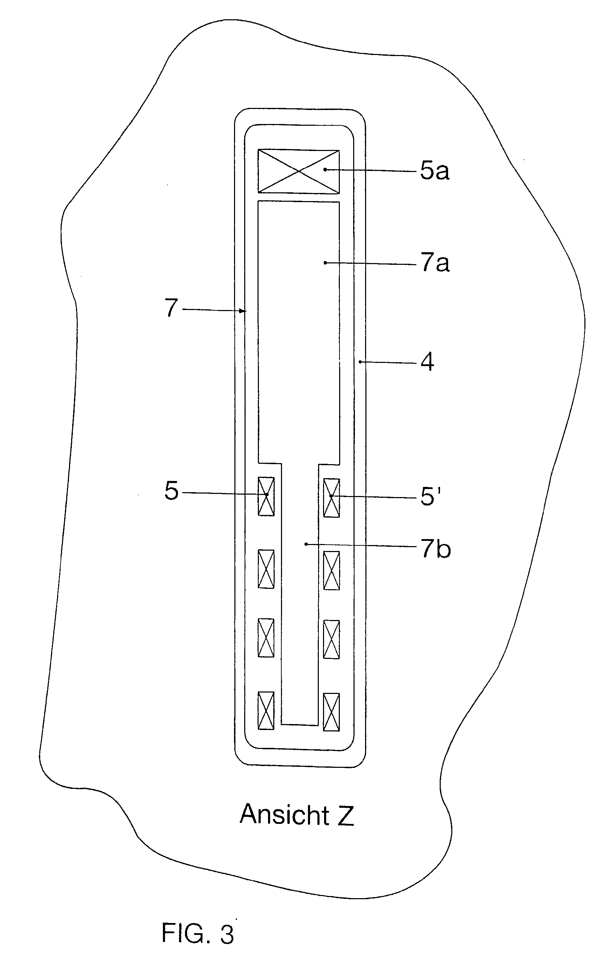

In Figur 3 ist eine Detailansicht einer Schleusenöffnung 7 bei geöffneter Klappe mit entlang des Öffnungsverlaufs der Schleusenöffnung angeordneten Magneteinrichtungen 5, 5', 5a dargestellt. Die Schleusenöffnung hat ein Öffnungsprofil mit einem ersten Spaltbereich 7a und einem zweiten Spaltbereich 7b, wobei der erste Spaltbereich 7a eine größere Breite als der zweite Spaltbereich 7b aufweist. Ein derartiges Schleusenöffnungsprofil ist dem Transport von an einem Substratcarrier senkrecht hängenden Substraten angepasst. Die Magneteinrichtungen 5, 5' umfassen den zweiten Schleusenöffnungsbereich 7b beidseitig. Die Magneteinrichtung 5a ist aus Platzgründen oberhalb des ersten Schleusenöffnungsbereichs 7a angeordnet. Das verformbare Dichtelement 4, vorzugsweise ein Rundschnurring, umschließt die Schleusenöffnung sowie die Magneteinrichtungen 5, 5'und 5a. Es versteht sich, dass auch ein anderer Verlauf des Dichtelements von der Erfindung umfasst wird.

Im Verschlusszustand sind die Magneteinrichtungen derart entlang des Verlaufs der Schleusenöffnung angeordnet, dass das Absperrorgan torsionsfrei und mit ausreichender Anpresskraft gegen das Dichtungselement 4 gepresst ist.

Die Magneteinrichtungen sind ferner derart ausgelegt, dass vorgegebene Werte des vom Absperrorgan auf das Dichtungselement ausgeübten Anpressdrucks realisierbar sind.

Gemäß der Erfindung ist die schaltbare Magneteinrichtung als eine vorzugsweise einteilige Magnetspule ausgebildet, die die Schleusenöffnung entlang des Öffnungsverlaufs ein- oder mehrfach umfasst.

Besonders günstig ist es, wenn die Befestigung einer Magnetspule durch Vergießen mit einer geeigneten vakuumtauglichen Vergussmasse in entsprechend vorgesehene Hohlräume der die Spule aufnehmenden Bauteile erfolgt. Hierzu können beispielsweise Epoxidharze wie Araldit oder ähnliche verwendet werden.

In einer bevorzugten Ausführungsform der Erfindung umfasst eine der Magneteinrichtungen eine Permanentmagnet-Komponente. Die andere Magneteinrichtung kann ebenfalls eine Permanentmagnet-Komponente umfassen. Hiermit kann ein stromloser Verschlusszustand der Schleusenöffnung erreicht werden. Zumindest eine der Magneteinrichtungen weist dabei eine schaltbare Magnetspule, mit der ein magnetisches Gegenfeld erzeugbar ist, auf. Damit kann ein Öffnungsimpuls bzw. eine negative Anpresskraft zwischen Absperrorgan und Gegenplatte erzeugt werden. Besonders bevorzugt ist es, wenn die Permanentmagnet-Einrichtungen für einen sicheren stromlosen Verschlusszustand gegenüber Atmosphärendruck ausgelegt sind, selbst wenn der Atmosphärendruck gegen die Schließrichtung auf das Absperrorgan wirkt.

In einer weiteren Ausführungsform der Erfindung umfassen beide Magneteinrichtungen eine Permanentmagnet-Komponente, so dass ein stromloser Verschlusszustand der Schleusenöffnung bewirkt werden kann. Ferner ist eine Antriebswelle vorgesehen, mit der Fließ- und Öffnungsbewegungen eingeleitet und beendet werden können. Es versteht sich, dass das dabei von der Antriebswelle zur Verfügung gestellte Drehmoment ausreichen muss, um die Anziehungskraft zwischen den Permanent-Magneten der beiden Magneteinrichtungen bei einer Öffnungsbewegung zu überwinden.

Während in der vorangehenden Beschreibung davon ausgegangen worden ist, dass beide Rezipienten Vakuumkammern sind, versteht es sich, dass auch Ausführungsformen von der Erfindung umfasst sind, bei der das Absperrorgan an der Trennstelle zwischen einem Rezipienten und einem Bereich mit dauerhaft anstehendem atmosphärischen Druck angeordnet ist.

### BEZUGSZEICHENLISTE

- VK1: Vakuumkammer 1
- VK2: Vakuumkammer 2
- 1: Kammerwand Vakuumkammer 1
- 1a: Verbindungsflansch Vakuumkammer 1
- 2: Schwenkwelle
- 3: Klappe
- 3a: Gegenplatte
- 4: Dichtungselement
- 5: Magnetspule
- 5': Magnetspule
- 5a: Magnetspule
- 6: Ferromagnetische Platte/Streifen
- 7: Schleusenöffnung
- 7a: Schleusenöffnungsbereich
- 7b: Schleusenöffnungsbereich
- 9: Kammerwand Vakuumkammer 2
- 9a: Verbindungsflansch Vakuumkammer 2
- 11: Lagerstelle Schwenkwelle
- 12: Schwenkantrieb
- 13: Drehdurchführung
- 14: Halterung für Schwenkantrieb
- 17: Schleusenöffnung

## Patentansprüche

1. Schleusenvorrichtung für eine in einer Wandung zwischen einem ersten und einem zweiten Rezipienten angeordneten Schleusenöffnung (7, 17), wobei die Schleusenvorrichtung ein im Innenraum des ersten Rezipienten anordenbares Absperrorgan aufweist, oder für eine Schleusenöffnung (7, 17) mit einem an einer Trennstelle zwischen einem Rezipienten und einem Bereich mit dauerhaft anstehendem atmosphärischen Druck anordenbaren Absperrorgan
und
einer dem Absperrorgan zugeordneten Gegenplatte (3a), wobei eine erste Magneteinrichtung in einem Bereich der Gegenplatte (3a) und eine der ersten Magneteinrichtung zugeordnete zweite Magneteinrichtung in einem Bereich des Absperrorgans vorgesehen ist und zum Schließen der Schleusenöffnung (7, 17) mittels der ersten und zweiten Magneteinrichtung eine positive Anpresskraft zwischen Absperrorgan und Gegenplatte (3a) erzeugbar ist,
**dadurch gekennzeichnet, dass**
die erste Magneteinrichtung als schaltbare Magnetspule (5) ausgebildet ist, die die Schleusenöffnung (7, 17) entlang des Öffnungsverlaufs ein- oder mehrfach umfasst und die zweite Magneteinrichtung eine ferromagnetische Komponente (6) aufweist.

2. Vorrichtung nach Anspruch 1, **dadurch gekennzeichnet, dass** die zweite Magneteinrichtung als ferromagnetische Platte oder Streifenanordnung oder als Klappe (3) aus ferromagnetischen Blech ausgebildet ist.

3. Vorrichtung nach Anspruch 1 oder 2, **dadurch gekennzeichnet, dass** die zweite Magneteinrichtung zumindest eine schaltbare Magnetspule (5') zur Erzeugung eines Magnetfeldes aufweist.

4. Vorrichtung nach einem der vorhergehenden Ansprüche, **dadurch gekennzeichnet, dass** zur Gewährleistung eines stromlosen Verschlusses der Schleusenöffnung (7, 17) eine der Magneteinrichtungen zusätzlich eine erste Permanentmagnet-Komponente umfasst und dass die andere Magneteinrichtung zusätzlich eine zweite Permanentmagnet Komponente umfasst.

5. Vorrichtung nach Anspruch 4, **dadurch gekennzeichnet, dass** die Magneteinrichtungen für einen stromlosen Verschlusszustand gegenüber Atmosphärendruck ausgelegt sind.

6. Vorrichtung nach einem der vorhergehenden Ansprüche, **dadurch gekennzeichnet, dass** eine nicht - gleichmäßig geformte Schleusenöffnung (7, 17) mit einem für einen Transport von an einem Substratcarrier senkrecht hängenden Substraten anpassbaren Schleusenöffnungsprofil vorgesehen ist.

7. Vorrichtung nach einem der vorhergehenden Ansprüche, **dadurch gekennzeichnet, dass** die Magneteinrichtungen derart entlang des Verlaufs der Schleusenöffnung (7, 17) angeordnet sind, dass das Absperrorgan im Verschlusszustand der Schleusenöffnung (7, 17) torsionsfrei ist.

8. Vorrichtung nach einem der vorhergehenden Ansprüche, **dadurch gekennzeichnet, dass** als Absperrorgan eine mittels einer Schwenkeinrichtung positionierbare schwenkbare Klappe (3) vorgesehen ist.

9. Vorrichtung nach einem der vorhergehenden Ansprüche, **dadurch gekennzeichnet, dass** als Absperrorgan eine mittels einer Schwenkeinrichtung positionierbare schwenkbare Klappe (3) aus einem ferromagnetischen Blech vorgesehen ist.

10. Vorrichtung nach einem der vorhergehenden Ansprüche, **dadurch gekennzeichnet, dass** als Absperrorgan eine mittels einer linearen Bewegungseinrichtung positionierbare Schiebereinrichtung mit einer Schieberplatte vorgesehen ist.

11. Vorrichtung nach Anspruch 8 oder 9, **dadurch gekennzeichnet, dass** die Schwenkeinrichtung hydraulisch, pneumatisch und/oder elektromechanisch betätigbar ist.

12. Vorrichtung nach Anspruch 10, **dadurch gekennzeichnet, dass** die Linearbewegungseinrichtung hydraulisch, pneumatisch und/oder elektromechanisch betreibbar ist.

13. Vorrichtung nach einem der vorhergehenden Ansprüche, **dadurch gekennzeichnet, dass** in einem Bereich der Gegenplatte (3a) und/oder des Absperrorgans ein verformbares Dichtelement (4), vorzugsweise ein Rundschnurring, vorgesehen ist.

## Claims

1. Lock device for a lock opening (7, 17), arranged in a wall between a first and a second recipient, wherein the lock device has a locking member that can be arranged in the interior of the first recipient, or for a lock opening (7, 17) with a locking member that can be arranged at a separation point between a recipient and a region under permanent atmospheric pressure, and
a aounterplate (3a) associated with the locking member, wherein provision is made for a first magnet apparatus in a region of the counterplate (3a) and for a second magnet apparatus, associated with the first magnet apparatus, in a region of the locking member and a positive pressure force can be generated between locking member and counterplate (3a) for the purpose of closing the lock opening (7, 17) by means of the first and second magnet apparatus,
**characterized in that**
the first magnet apparatus is embodied as a switchable magnet coil (5), which encircles the lock opening (7, 17) along the opening profile once or a number of times, and **in that** the second magnet apparatus has a ferromagnetic component (6).

2. Device according to Claim 1, **characterized in that** the second magnet apparatus is embodied as a ferromagnetic plate or strip arrangement or as a flap (3) made out of a ferromagnetic sheet.

3. Device according to Claim 1 or 2, **characterized in that** the second magnet apparatus has at least a switchable magnet coil (5') for generating a magnetic field.

4. Device according to one of the preceding claims, **characterized in that**, in order to ensure currentless locking of the lock opening (7, 17), one of the magnet apparatuses additionally comprises a first permanent magnet component and **in that** the other magnet apparatus additionally comprises a second permanent magnet component.

5. Device according to Claim 4, **characterized in that** the magnet apparatuses are designed for a currentless locked state with respect to atmospheric pressure.

6. Device according to one of the preceding claims, **characterized in that** provision is made for an irregularly shaped lock opening (7, 17) with a lock-opening profile that can be matched to a transport of substrates hanging vertically from a substrate carrier.

7. Device according to one of the preceding claims, **characterized in that** the magnet apparatuses are arranged along the profile of the lock opening (7, 17) such that the locking member is torsion-free in the locked state of the lock opening (7, 17).

8. Device according to one of the preceding claims, **characterized in that** a pivotable flap (3) that can be positioned by means of a pivot apparatus is provided as locking member.

9. Device according to one of the preceding claims, **characterized in that** a pivotable flap (3) that is made out of a ferromagnetic sheet and can be positioned by means of a pivot apparatus is provided as locking member.

10. Device according to one of the preceding claims, **characterized in that** a slide apparatus with a slide plate that can be positioned by means of a linear movement apparatus is provided as locking member.

11. Device according to Claim 8 or 9, **characterized in that** the pivot apparatus can be actuated hydraulically, pneumatically and/or electromechanically.

12. Device according to Claim 10, **characterized in that** the linear movement apparatus can be operated hydraulically, pneumatically and/or electromechanically.

13. Device according to one of the preceding claims, **characterized in that** a deformable sealing element (4), preferably a toroidal sealing ring, is provided in a region of the counterplate (3a) and/or of the locking member.

## Revendications

1. Dispositif de sas pour une ouverture de sas (7, 17) disposée dans une paroi entre un premier et un deuxième récipient, le dispositif de sas présentant un organe d'arrêt pouvant être disposé dans l'espace intérieur du premier récipient ou pour une ouverture de sas (7, 17) comprenant un organe d'arrêt pouvant être disposé au niveau d'un point de séparation entre un récipient et une région à la pression atmosphérique existant de manière durable, et
avec une plaque conjuguée (3a) associée à l'organe d'arrêt, un premier dispositif d'aimant étant prévu dans une région de la plaque conjuguée (3a) et un deuxième dispositif d'aimant associé au premier dispositif d'aimant étant prévu dans une région de l'organe d'arrêt et une force de pressage positive entre l'organe d'arrêt et la plaque conjuguée (3a) pouvant être générée pour fermer l'ouverture de sas (7, 17) au moyen du premier et du deuxième dispositif d'aimant,
**caractérisé en ce que**
le premier dispositif d'aimant est réalisé sous forme de bobine magnétique commutable (5) qui entoure une ou plusieurs fois l'ouverture de sas (7, 17) le long de l'étendue de l'ouverture et le deuxième dispositif magnétique présente un composant ferromagnétique (6).

2. Dispositif selon la revendication 1, **caractérisé en ce que** le deuxième dispositif d'aimant est réalisé sous forme de plaque ferromagnétique ou d'agencement en forme de bande ou sous forme de volet (3) en tôle ferromagnétique.

3. Dispositif selon la revendication 1 ou 2, **caractérisé en ce que** le deuxième dispositif magnétique présente au moins une bobine magnétique commutable (5') pour générer un champ magnétique.

4. Dispositif selon l'une quelconque des revendications précédentes, **caractérisé en ce que** pour garantir une fermeture sans courant de l'ouverture de sas (7, 17), l'un des dispositifs d'aimant comprend en outre un premier composant d'aimant permanent et **en ce que** l'autre dispositif d'aimant comprend en outre un deuxième composant d'aimant permanent.

5. Dispositif selon la revendication 4, **caractérisé en ce que** les dispositifs d'aimant sont conçus pour un état de fermeture sans courant vis-à-vis de la pression atmosphérique.

6. Dispositif selon l'une quelconque des revendications précédentes, **caractérisé en ce qu'**une ouverture de sas (7, 17) formée de manière non uniforme est pourvue d'un profil d'ouverture de sas pouvant être adapté en vue d'un transport de substrats accrochés verticalement sur un support de substrats.

7. Dispositif selon l'une quelconque des revendications précédentes, **caractérisé en ce que** les dispositifs d'aimant sont disposés le long de l'étendue de l'ouverture de sas (7, 17) de telle sorte que l'organe d'arrêt ne soit soumis à aucune torsion dans l'état de fermeture de l'ouverture de sas (7, 17).

8. Dispositif selon l'une quelconque des revendications précédentes, **caractérisé en ce que** l'on prévoit en tant qu'organe d'arrêt un volet pivotant (3) pouvant être positionné au moyen d'un dispositif de pivotement.

9. Dispositif selon l'une quelconque des revendications précédentes, **caractérisé en ce que** l'on prévoit en tant qu'organe d'arrêt un volet pivotant (3) constitué d'une tôle ferromagnétique pouvant être positionné au moyen d'un dispositif de pivotement.

10. Dispositif selon l'une quelconque des revendications précédentes, **caractérisé en ce que** l'on prévoit en tant qu'organe d'arrêt un dispositif coulissant avec une plaque coulissante pouvant être positionné au moyen d'un dispositif de déplacement linéaire.

11. Dispositif selon à revendication 8 ou 9, **caractérisé en ce que** le dispositif de pivotement peut être actionné par voie hydraulique, pneumatique et/ou électromécanique.

12. Dispositif selon la revendication 10, **caractérisé en ce que** le dispositif de déplacement linéaire peut être commandé par voie hydraulique, pneumatique et/ou électromécanique.

13. Dispositif selon l'une quelconque des revendications précédentes, **caractérisé en ce que** dans une région de la plaque conjuguée (3a) et/ou de l'organe d'arrêt est prévu un élément d'étanchéité déformable (4), de préférence un joint torique d'étanchéité.
